# EUROPEAN PATENT APPLICATION

(11) **EP 2 336 699 A1**
(43) Date of publication of application: **22.06.2011**
(21) Application number: 09808051.8
(22) Date of filing: 17.08.2009
(51) Int. Cl.: F28D 9/00, F24F 7/08

(54) **HEAT EXCHANGE DEVICE AND HEAT GENERATING ELEMENT CONTAINING DEVICE USING SAME**

(30) Priority: 18.08.2008 JP 2008209644
(71) Applicant: Panasonic Corporation, Kadoma-shi Osaka 571-8501 (JP)
(72) Inventor: SUGIYAMA, Makoto, Osaka 540-6207 (JP); MURAYAMA, Takuya, Osaka 540-6207 (JP); NOGAMI, Wakana, Osaka 540-6207 (JP)
(74) Representative: Schwabe - Sandmair - Marx
(86) International application number: PCT/JP2009/003903
(87) International publication number: WO 2010/021115

(57) **Abstract**

A heat exchange unit main body case (11) including a first blast fan (12) for a first environment and a second blast fan (13) for a second environment, and a first heat exchanger (14) and a second heat exchanger (15) for exchanging a heat between the first environment and the second environment in the main body case (11), in which the first air blast fan (12), the second air blast fan (13), the first heat exchanger (14) and the second heat exchanger (15) being disposed essentially in a row, and air blast paths (an outside air blast path (16) and an inside air blast path (17)) being formed between the first heat exchanger (14) and the second heat exchanger (15) and a side face (11a) of the main body case (11) for communicating from one of the first and the second blast fan to the first heat exchanger (14) and the second heat exchanger (15); with this structure, a pressure loss being controlled and heat exchange efficiency being enhanced and miniaturization of the heat exchanger itself being made possible.

## Description

### TECHNICAL FIELD

The invention relates to a heat exchange unit and a heating object container using the heat exchange unit.

### BACKGROUND ART

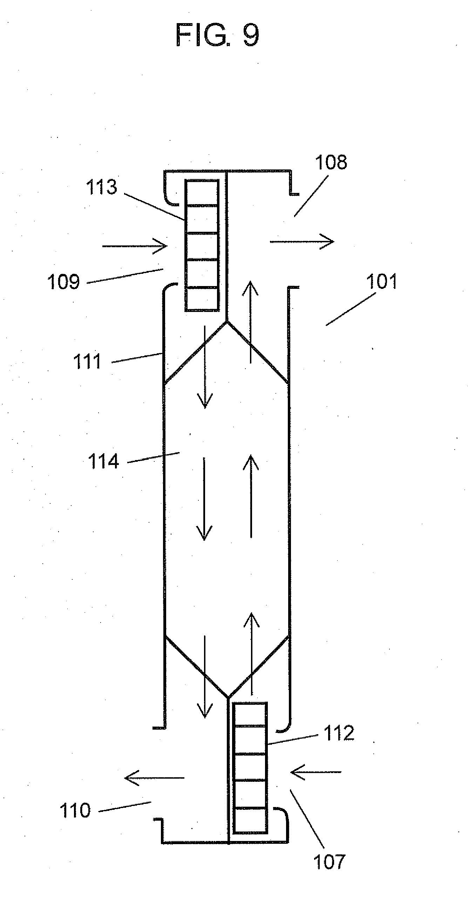

A base station of mobile telephone is presented as an example of heating object as it flows a current of over several tens amperes. For such an apparatus, cooling is significantly important for stabilizing its performance. The base station for a mobile telephone of this kind has a cooling mechanism as is shown in Fig. 9.

Fig. 9 is a block diagram of a conventional heat exchange unit. In Fig. 9, the unit is composed of a cabinet containing a transmitter-receiver, a heating object, and heat exchange unit 101 installed at an opening of the cabinet. Heat exchange unit 101 is composed of main body case 111 having first inflow mouth 107 and first outflow mouth 108 for outside air, second inflow mouth 109 and second outflow mouth 110 for an air in the cabinet. Main body case 111 includes first blast fan 112 for outside air, second blast fan 113 for the air inside the cabinet, and heat exchanger 114 for exchanging heat between an outside air and an inside air (reference is made to patent document 1).

With above conventional heat exchange unit, one heat exchanger 114 is installed in one main body case 111. Because of this structure, a laminate dimension (air path cross section) of heat exchanger 114 is defined by a maximum cross section of main body case 111. Therefore, in order to obtain desired heat exchange efficiency, a dimension of a heat-transfer element of heat exchanger 114 has to be increased. Namely, an air path in heat exchanger 114 has to be made longer. Pressure loss in the air path of heat exchanger 114 becomes high, and capacity of air blower (first blast fan 112 and second blast fan 113) has to be increased. Since downsizing of a base station for the mobile telephone is proceeding, miniaturization of the heat exchange unit is also required.

### PARIOR ART DOCUMENT

Patent document 1: Japanese Patent Unexamined Publication No. 2000-161875

### SUMMARY OF THE INVENTION

This invention controls a pressure loss in a heat exchange unit, improves heat efficiency, and as a result miniaturizes the unit.

The invention includes a main body case, a first blast fan, a second blast fan and a plurality of heat exchangers disposed in the main body case. The main body case further includes a first inflow mouth and a first outflow mouth for a first environment formed at a front side thereof, and a second inflow mouth and second outflow mouth for a second environment formed at a rear side thereof. The first blast fan draws in a first environment air through the first inflow mouth and blasts the air to the plurality of heat exchangers. The second blast fan draws in a second environment air through the second inflow mouth and blasts the air to the plurality of heat exchangers. The plurality of heat exchangers exchanges a heat between the first environment air and the second environment air in the main body case. The first heat exchanger, the second heat exchanger and the plurality of heat exchangers are lined up essentially in a row. An air blast path is formed between the plurality of heat exchangers and a wall face of the main body case. The air blast path communicates from at least one of the first blast fan and the second blast fan to the heat exchangers.

With this arrangement of using a plurality of exchangers, a cross section of the air path is larger than an arrangement of using one heat exchanger. In other words, a total dimension of air inlet of the plurality of heat exchangers is larger than a dimension of air inlet of one heat exchanger, namely the cross section is larger. Therewith, an air path of each heat exchanger is controlled shorter. Consequently, velocity of the air passing through the heat exchanger is lower, enhancing heat exchange efficiency. Pressure loss for each heat exchanger is also reduced. Accordingly, miniaturization of the heat exchanger is made possible.

### BREIEF DESCRIPTION OF THE DRAWINGS

Fig. 1 is a perspective view of an installation example of a heating object container utilizing a heat exchange unit according to exemplary embodiment 1 of the invention.
Fig. 2 is a cross sectional view of a heat exchange unit according to exemplary embodiment 1 of the invention.
Fig. 3 is an exploded perspective view of the heat exchange unit according to exemplary embodiment 1 of the invention.
Fig. 4 is a detailed perspective view of a blast path intersecting part of the heat exchange unit according to exemplary embodiment 1 of the invention.
Fig. 5 is an exploded perspective view of a heat exchange unit according to exemplary embodiment 2 of the invention.
Fig. 6 is a cross sectional view of a heat exchange unit according to exemplary embodiment 3 of the invention.
Fig. 7 is an exploded perspective view of a heat exchange unit according to exemplary embodiment 3 of the invention.
Fig 8 is an exploded perspective view of a heat exchange unit according to exemplary embodiment 4 of the invention.
Fig. 9 is a block diagram of a conventional heat exchange unit.

### DETAILED DESCRIPTION OF PREFERRED EMBODIMENTS

Below, preferred embodiments of the invention are described using drawings.

### FIRST EXEMPLARY EMBODIMENT

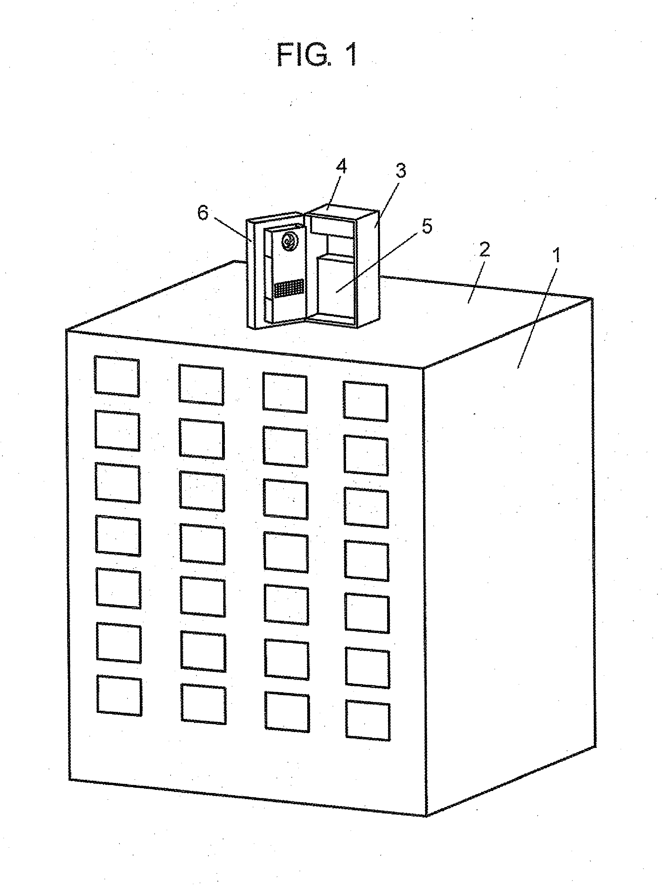

Fig. 1 is a perspective view of an installed example of a heating object container utilizing a heat exchange unit according to exemplary embodiment 1 of the invention. In Fig. 1, mobile phone base station 3 is installed on roof 2 of building 1. Mobile phone base station 3 is a heating object container. Base station 3 is composed of cabinet 4 in a box shape, transmitter-receiver 5 installed in cabinet 4, and heat exchange unit 6 attached to a front opening of cabinet 4 in a freely openable-and-cloasable manner like a door.

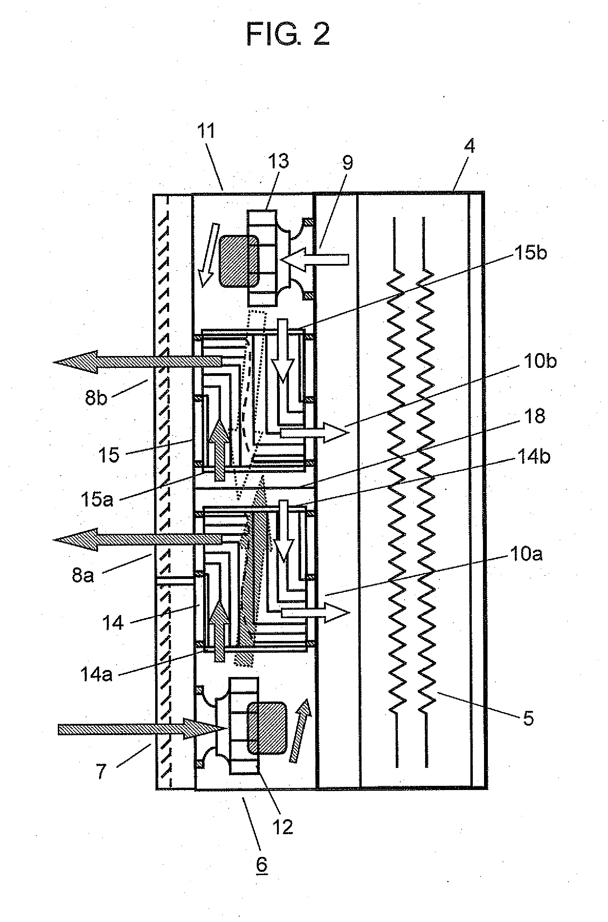

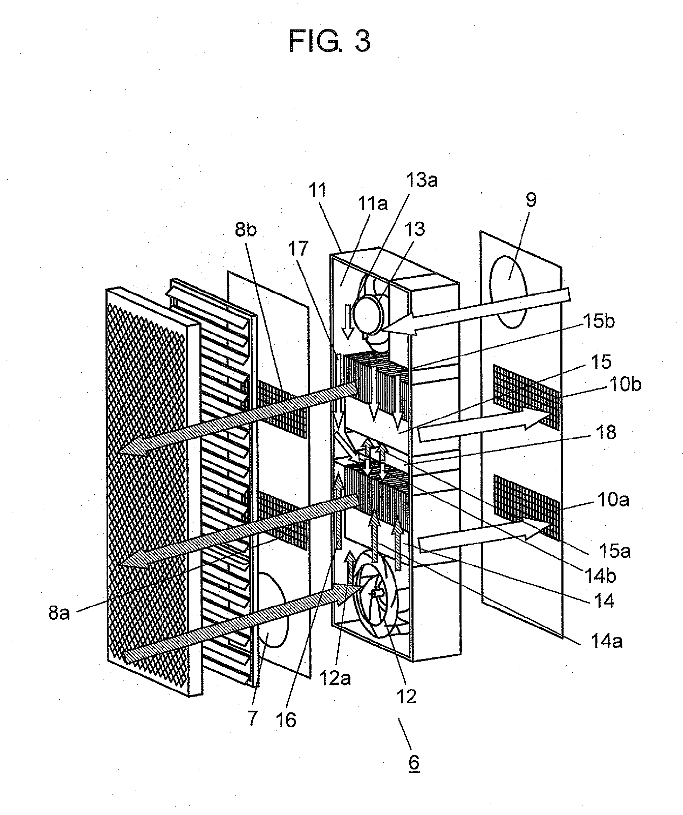

A structure of heat exchange unit 6 is explained with reference to Figs. 2 and 3. Fig. 2 is a cross sectional view of a heat exchange unit according to exemplary embodiment 1. Fig. 3 is an exploded perspective view of the heat exchange unit of embodiment 1. As in Figs. 2 and 3, heat exchange unit 6 is made up of main body case 11 of the unit. In main body case 11, first blast fan 12 for an outside air (a first environment) and second blast fan 13 for an air inside cabinet 4 (a second environment, hereinafter called "inside air") are included. Main body case 11 also includes first heat exchanger 14 and second heat exchanger 15 for exchanging a heat between the outside air and the inside air. At a side of the outside air (front side) of main body case 11, first inflow mouth 7 and first outflow mouth 8a and 8b for the outside air are formed. At a cabinet side (rear side) of main body case 11, second inflow mouth 9 and second outflow mouth 10a and 10b for the inside air are formed. In main body case 11, first blast fan 12, first heat exchanger 14, second heat exchanger 15 and second blast fan 13 are lined up essentially in a row in this order from a bottom to a top of the case.

Although not specifically illustrated, first heat exchanger 14 and second heat exchanger 15 are both composed of a plurality of synthetic resin plates stacked with a predetermined space. The plate is in a rectangular shape, long in an up-and-down direction and each plate having a plurality of straightening vanes in a lane shape cut on a surface of the plate. The straightening vane is extended from a short side edge of the rectangle plate, an air inlet toward an edge in an opposite side of the plate. The vane is curved before the edge toward a long side edge of the plate and is communicated to an air outlet. The plate has a plurality of such straightening vanes, forming a plurality of L shape air blast lanes.

In Fig. 3, first heat exchanger 14 and second heat exchanger 15 has an air inlet for the outside air at a bottom side thereof. An outside air inlet of the first heat exchange is first inlet 14a, and the outside air inlet of the second heat exchanger is first inlet 15a. An outside air outlet of the first heat exchanger is connected to first outflow mouth 8a, and an outside air outlet of the second heat exchanger is connected to first outflow mouth 8b. While, first heat exchanger 14 and second heat exchanger 15 has an air inlet for the inside air at a top side thereof. An inside air inlet of the first heat exchanger is second inlet 14b and an inside air inlet of the second heat exchanger is second inlet 15b. The inside air outlet of the first heat exchanger is connected to second outflow mouth 10a, and the inside air outlet of the second heat exchanger is connected to second outflow mouth 10b. Accordingly, in first heat exchanger 14, an outside air is flown in from first inlet 14a and flown out from first outflow mouth 8a. In second heat exchanger 15, the outside air is flown in from first inlet 15a and flown out from first outflow mouth 8b. Such outside air paths through the first heat exchanger and the second heat exchanger make up an outside air path (air path for first environment). Similarly, in first heat exchanger 14, an inside air is flown in from second inlet 14b and is flown out from second outflow mouth 10a. In second heat exchanger 15, the inside air is flown in from second inlet 15b and is flown out from second outflow mouth 10b. Such inside air paths through the first heat exchanger and the second heat exchanger make up an inside air path (air path for second environment).

In Fig. 2, with regard to first heat exchanger 14 and second heat exchanger 15, the inside air path (air path for second environment) has a blast lane having a shorter air path at a side of cabinet 4 (right side in Fig. 2) and a blast lane having a longer air path at a side of the outside air (left in Fig 2). The outside air path (air path for second environment) has a blast lane with longer air path at a side of cabinet 4 and a blast lane having a shorter air path at the side of the outside air.

In Fig. 3, outside air blast path 16 (air blast path for the first environment) is formed between first heat exchanger 14 and side face 11a of main body case 11, communicating from first blast fan 12 to second heat exchanger 15. Likewise, inside air blast path 17 (air blast path for the second environment) is formed between second heat exchanger 15 and side face 11a of main body case 11, communicating from second blast fan 13 to first heat exchanger 14.

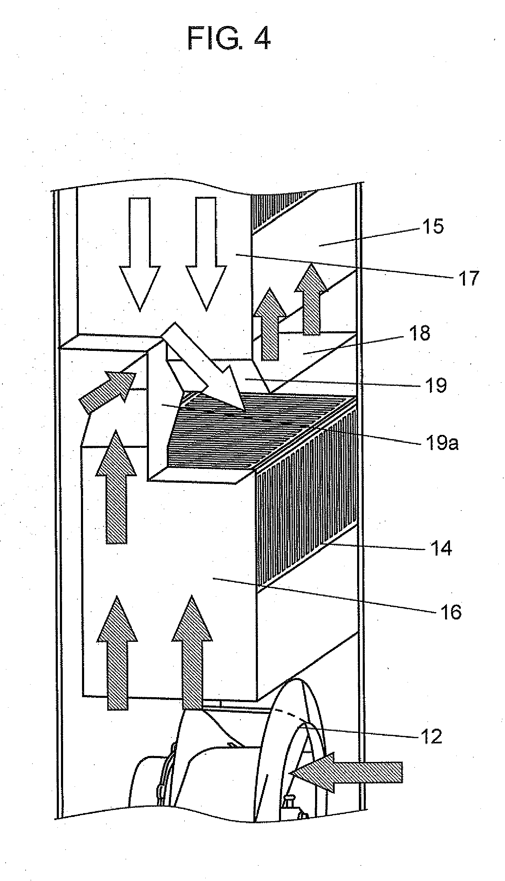

Outside air blast path 16 and inside air blast path 17 are intersected in-between first heat exchanger 14 and second heat exchanger 15. That is, blast path dividing plate 18 is placed between a top side of first heat exchanger 14 (second inlet 14b) and a bottom side of second heat exchanger 15 (first inlet 15a), facing each side. The intersection of the air blast paths is explained next with Fig. 4.

Fig. 4 is a detailed perspective view of the blast path intersection of the heat exchange unit according to exemplary embodiment 1 of the invention, looked from a rear side in Fig. 3. In Fig. 4, blast path intersection 19 is structured so that the outside air blast path 16 may communicate to a space above blast path dividing plate 18 (a side of second heat exchanger 15), and inside air blast path 17 may communicate to a space below blast path dividing plate 18 (a side of first heat exchanger 14). In blast path intersection 19, intersection dividing plate 19a is placed vertically crossing side face 11a (front side in Fig. 4) of main body case 11 and blast path dividing plate 18 at right angles. Blast path dividing plate 18 and intersection dividing plate 19a constitute blast path intersection 19.

Working principle of above structured heat exchange unit is explained. In Figs. 2 and 3, an inside air heated to a high temperature in cabinet 4 by transmitter-receiver 5 is drawn in by second blast fan 13 through second inflow mouth 9 of heat exchange unit 6. The inside air drawn in by second blast fan 13 is partially forwarded to second inlet 15b of second heat exchanger 15 and the rest is forwarded to second inlet 14b of first heat exchanger 14 through inside air blast path 17. Meanwhile, a cool outside air is drawn in by first blast fan 12 through first inflow mouth 7. The outside air drawn in by the first blast fan is partially forwarded to first inlet 14a of first heat exchanger 14 and the rest is forwarded to first inlet 15a of second heat exchanger 15 through outside air blast path 16. First heat exchanger 14 and second heat exchanger 15 transfer a heat from the hot inside air to the cool outside air. The inside air cooled down by the heat transference is blown out to cabinet 4 through second outflow mouths 10a and 10b. The outside air is then blown out to outside again through first outflow mouth 8a and 8b.

Next, air flow at blast path intersection 19 is explained. In Fig. 4, an outside air blown through outside air blast path 16 passes a cabinet side of intersection dividing plate 19a (left side in Fig.4) and is forwarded to air inlet 15a of second heat exchanger 15. Then, the outside air passed through blast path intersection 19 is blown out through the long air blast lane of second heat exchanger 15 (right side in Fig. 4). Similarly, the inside air blown through inside air blast path 17 passes an outside air side of intersection dividing plate 19a (right side in Fig. 4) and is forwarded to inlet 14b of first heat exchanger 14. The inside air passed through blast path intersection 19 is blown out through a long air blast lane of first heat exchanger 14 (right side in Fig. 4).

As described, by using two heat exchangers (first heat exchanger 14 and second heat exchanger 15) for exchanging a heat of a dimension otherwise of one heat exchanger, a cross section of the air path is larger. In other words, having two heat exchangers 14 and 15, a total dimension of air inlet 14a and 15a or of 14b and 15b is larger than a dimension of an inlet of one heat exchanger, so the cross section of the air path is larger. An air path of each heat exchanger is controlled shorter for passing an amount of air. Velocity of the air passing through each heat exchanger is consequently lower, enhancing heat exchange efficiency. Pressure loss for each heat exchanger is also reduced. Accordingly, miniaturization of the heat exchanger itself is made possible.

Blast path dividing plate 18 is disposed preferably slanting so that a wider space is given to a side of the longer air blast lane of inlet 15a and 14b of the first heat exchanger 14 and second heat exchanger 15. In Fig. 4, blast path dividing plate 18 is disposed in parallel with a top surface of first heat exchanger 14 and a bottom surface of second heat exchanger 15. But, the blast path dividing plate 18 is preferably slanting from a cabinet side (left side in Fig. 4) to an outside air side (right side in Fig. 4). With this arrangement, a larger amount of air is forwarded to the longer air blast lane. The air is consequently sent to the longer and the shorter blast lanes balanced, or the air is evenly forwarded to an entire part of the heat exchanger. Accordingly, heat exchange efficiency is enhanced. Further, by blasting more inside and outside air to the longer air blast lane of first and second heat exchanger 14 and 15, a higher pressure is applied to the longer blast lane having a larger pressure drop. As a result, the amount of blasted air is supplied between the longer blast lane and the shorter blast lane in balance, enhancing the heat exchange efficiency.

Although not illustrated, a heat sink plate or some other heat sink device may be attached to blast path dividing plate 18 dividing the outside blast path 16 and inside blast path 17. With this arrangement, heat exchange is facilitated between outside air blast path 16 and inside air blast path 17. The heat sink plate preferably has a heat sink fin in parallel with a flowing direction of the air inside the blast path.

Further, a heat sink plate may be placed inside air blast path 17, attached to side face 11a of main body case 11, where a high temperature inside air flows. With this arrangement, heat transfer to an outside air is facilitated.

Otherwise, a heat exchanging device, inside which air blast paths intersects, may be placed in blast path intersection 19. Intersection of the air blast paths is therewith realized, making a heat exchange between outside air blast path 16 and inside air blast path 17.

A stacking pitch of second heat exchanger 15 is preferably wider at a side of an outside air than a stacking pitch of first heat exchanger 14 at a side of the outside air. Since second heat exchanger 15 is placed away from first blast fan 12, the air path till the second heat exchanger is longer. If the outside air is forwarded without any measure taken, much air is sent to the first heat exchanger than to the second heat exchanger. By making the stacking pitch of the heat exchanger facing a longer air path wider, an amount of the outside air passing through first heat exchangers 14 and second heat exchanger 15 is balanced. Thus, a capacity of both heat exchangers is evenly utilized, enhancing the entire heat exchange efficiency.

Similarly, by making a stacking pitch of first heat exchanger 14 at a side of the inside air wider than a stacking pitch of second heat exchanger 15 at a side of an outside air, an amount of inside air passing through first heat exchanger 14 and second heat exchanger 15 is balanced.

Furthermore, the stacking pitch of first heat exchanger 14 at a side of the outside air and the stacking pitch of second heat exchanger 15 at a side of the inside air are preferably made equal, as well as the stacking pitch of first heat exchanger 14 at a side of the inside air and the stacking pitch of second heat exchanger 15 at a side of the outside air equal. With this arrangement, heat exchange efficiency is balanced between first heat exchanger 14 and second heat exchanger 15, enhancing a heat exchange efficiency of entire heat exchange unit 6.

First blast fan 12 (second blast fan 13) is preferably turned in a direction of an opening of outside air blast path 16 (inside air blast path 17). In Fig. 3, by looking first blast fan 12 from first inflow mouth 7, outside air blast path 16 is formed at left side of fan 12 in an upward direction. First blast fan 12 is turned in a clockwise direction so a tangent arrow line along first blast fan 12 (indicating turning direction 12a of the first blast fan) is directed toward outside air blast path 16. Meanwhile, second blast fan 13 is turned in a counterclockwise so that a tangent arrow line of second blast fan 13 (turning direction 13a of second blast fan) is directed toward inside air blast path 17. With this structure, much smooth air flow of the outside air and the inside air is created, enhancing the heat exchange efficiency.

### SECOND EXEMPLARY EMBODIMENT

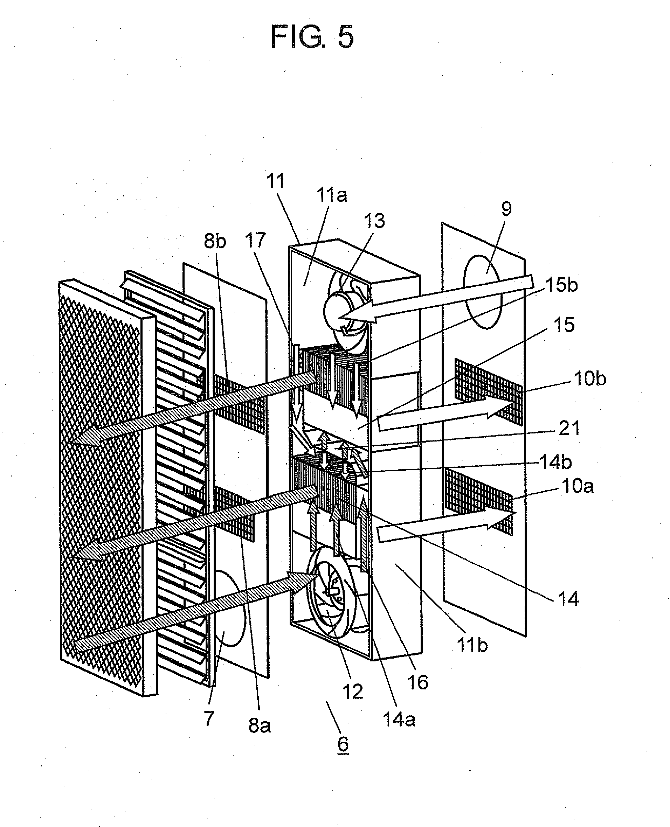

Exemplary embodiment 2 of the invention is explained with Fig. 5. Fig. 5 is an exploded perspective view of a heat exchange unit according to exemplary embodiment 2 of the invention. As shown in Fig. 5, in embodiment 2, similar to embodiment 1, first blast fan 12, first heat exchanger 14, second heat exchanger and second blast fan 13 are lined up essentially in a row in this order from a bottom of main body case 11. In this exemplary embodiment, however, different from embodiment 1, outside air blast path 16 is formed between side face 11b of main body case 11 and first heat exchanger 14, and inside air blast path 17 is formed between side face 11a opposed to side face 11b and second heat exchanger 15. A top face of first heat exchanger 14 and a bottom face of second heat exchanger 15 are shifted by a dimension of a horizontal cross section of outside air blast path 16 (or of inside air blast path 17). Space between first heat exchanger 14 and second heat exchanger 15 is divided by blast path dividing plate 21. The dividing plate connects a top edge of first heat exchanger 14 an edge at a side of outside air blast path 16 and a bottom edge of second heat exchanger 15 an edge at a side of inside air blast path 17, separating outside air and inside air. Namely, blast path dividing plate 21 is placed in a middle of the bottom face of first heat exchanger 14 and the top face of second heat exchanger 15.

With this structure, using two heat exchangers (first heat exchanger 14 and second heat exchanger 15) for exchanging a heat of a dimension otherwise of one heat exchanger, a cross section of the air path is larger. In other words, having two heat exchangers 14 and 15, a total dimension of air inlet 14a and 15a or of 14b and 15b is larger than a dimension of an inlet of one heat exchanger, so the cross section of the air path is larger. An air path of each heat exchanger is therefore held shorter for passing an amount of air. Velocity of the air passing through each heat exchanger is consequently lower, enhancing heat exchange efficiency. Pressure loss for each heat exchanger is also reduced. Accordingly, miniaturization of the heat exchanger is made possible.

Similar to exemplary embodiment 1, a stacking pitch of second heat exchanger 15 at a side of an outside air is preferably wider than a stacking pitch of first heat exchanger 14 at a side of an outside air. A stacking pitch of first heat exchanger 14 at a side of an inside air is preferably wider than a stacking pitch of second heat exchanger 15 at a side of an outside air. With this arrangement, an amount of the inside air and the outside air passing through first heat exchangers 14 and second heat exchanger 15 is balanced. Thus, a capacity of both heat exchangers is evenly utilized, enhancing the heat exchange efficiency of the entire heat exchange unit.

Furthermore, the stacking pitch of first heat exchanger 14 at a side of the outside air and the stacking pitch of second heat exchanger 15 at a side of the inside air are preferably equal, as well as the stacking pitch of first heat exchanger 14 at a side of the inside air and the stacking pitch of second heat exchanger 15 at a side of the outside air equal being equal. With this arrangement, heat exchange efficiency is balanced between first heat exchanger 14 and second heat exchanger 15, enhancing the entire heat exchange efficiency.

Although not illustrated, a heat sink plate or some other heat sink device may be attached to blast path dividing plate 18 dividing the outside blast path 16 and inside blast path 21. With this arrangement, heat exchange between outside air blast path 16 and inside air blast path 17 is facilitated.

Further, a heat sink plate may be placed inside air blast path 17, attached to side face 11b of main body case 11, where a high temperature inside air flows. With this arrangement, heat of high temperature inside air is transferred to an outside air, further enhancing the heat exchange efficiency.

Blast path dividing plate 21 is disposed preferably slanting so that a wider space is given to a side of a longer air blast lane of the inlet of the first heat exchanger 14 and second heat exchanger 15. In Fig. 5, when an inside air is flown through inside air blast path 17 to inlet 14b of first heat exchanger 14, blast path dividing plate 18 is slanted from the front side down to an inner side (cabinet side) because the air blast lane of first heat exchanger 14 is longer at a front side (outside air side). At this time, at inlet 15a of second heat exchanger 15, the dividing plate is slanted so that a wider space is given to the inner side where the longer air blast lane of 15 faces. With this structure, more of the air is blasted to the longer air blast lanes. Consequently, an amount of air passing through the long blast lane and the short blast lane is balanced, enhancing heat exchange efficiency.

Thus, by blasting more of the inside air and the outside air to the longer air blast lane of first and second heat exchanger 14 and 15, a higher pressure is applied to the longer blast lane where otherwise causes a large pressure drop. As a result, the amount of the passing air is balanced between the longer blast lane and the shorter blast lane, enhancing the heat exchange efficiency.

### THIRD EXEMPLARY EMBODIMENT

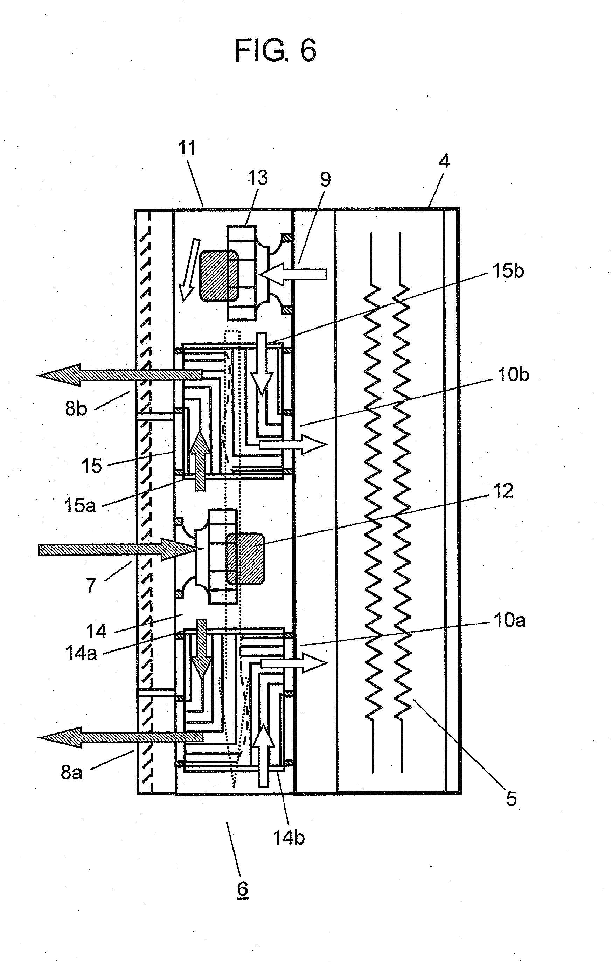

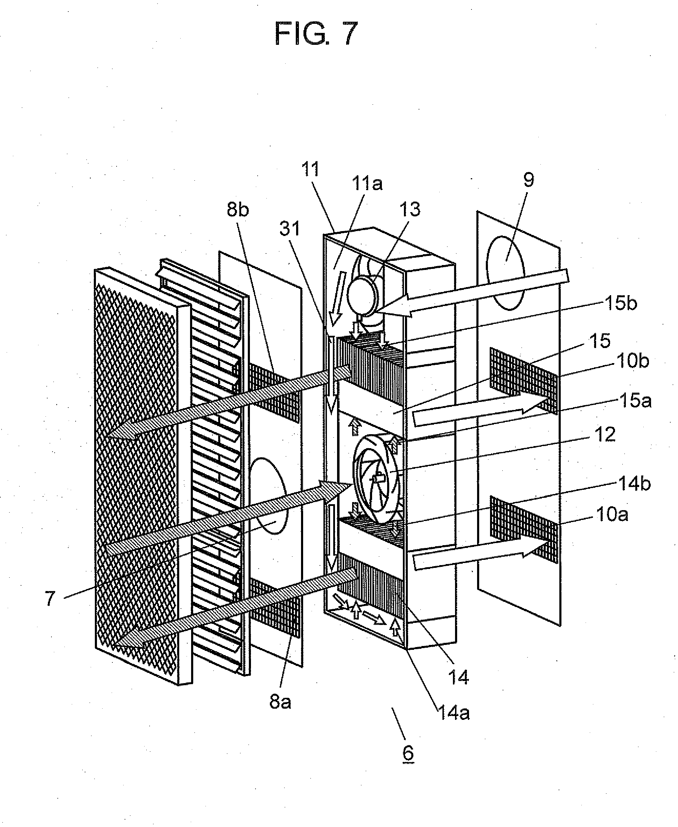

Exemplary embodiment 3 is explained with reference to Figs. 6 and 7. Fig. 6 is a cross sectional view of a heat exchange unit according to exemplary embodiment 3 of the invention. Fig. 7 is an exploded perspective view of a heat exchange unit according to exemplary embodiment 3 of the invention.

As shown in Figs. 6 and 7, in embodiments 3, different from embodiments 1 and 2, first heat exchanger 14, first blast fan 12, second heat exchanger 15 and second blast fan 13 are lined up in this order essentially in a row from a bottom of main body case 11. First heat exchanger 14 has first inlet 14a for an outside air at a top of it and second inlet 14b for an inside air at a bottom of it. Second heat exchanger 15 has first inlet 15a for the outside air on its bottom and second inlet 15b for the inside air on its top. Between side face 11a of main body case 11 and first heat exchanger 14 and heat exchanger 15, inside air blast path 31 is formed communicating second blast fan 13 and second inlet 14b of first heat exchanger 14.

With the heat exchange unit structured as above, an inside air heated to a high temperature in cabinet 4 by transmitter-receiver 5 is drawn in by second blast fan 13 through second inflow mouth 9 of heat exchange unit 6. The inside air drawn in is blasted by second blast fan 13. The air is partially forwarded to second inlet 15b of second heat exchanger 15 and the rest is forwarded to second inlet 1 of first heat exchanger 14 through inside air blast path 31. A cool outside air is drawn in by first blast fan 12 through first inflow mouth 7. The drawn in outside air is blasted by first blast fan 12. It is partially forwarded to first inlet 14a of first heat exchanger 14 and the rest is forwarded to first inlet 15a of second heat exchanger 15. First heat exchanger 14 and second heat exchanger 15 transfer a heat from the high temperature hot inside air to the cool outside air, and the cooled inside air is blown out into cabinet 4 through second outflow mouths 10a and 10b. The outside air is blown out to an outside again through first outflow mouth 8a and 8b.

With this structure, by using two heat exchangers (first heat exchanger 14 and second heat exchanger 15) for exchanging a heat of a dimension otherwise of one heat exchanger, a cross section of the air path is larger. In other words, having two heat exchangers 14 and 15, a total dimension of air inlet 14a and 15a or of 14b and 15b is larger than a dimension of an inlet of one heat exchanger, so the cross section of the air path is larger. An air path of each heat exchanger is held shorter for passing an amount of air. Velocity of the air passing through each heat exchanger is consequently lower, enhancing heat exchange efficiency. Pressure loss for each heat exchanger is reduced. Accordingly, miniaturization of the heat exchanger is made possible.

A stacking pitch of first heat exchanger 14 is preferably wider at a side of an inside air than a stacking pitch of second heat exchanger 15 at a side of the inside air. A stacking pitch of first heat exchanger 14 at a side of an inside air is preferably wider than a stacking pitch of second heat exchanger 15 at a side of the outside air. With this arrangement, an amount of the outside air and an inside air passing through first heat exchangers 14 and second heat exchanger 15 is balanced. Thus, a capacity of each heat exchanger is evenly utilized, enhancing heat exchange efficiency of the entire unit.

Although not illustrated, a heat sink plate or some other heat sink device may be placed inside air blast path 31, attached to side face 11b of main body case 11, where a high temperature inside air flows. With this arrangement, heat of a high temperature inside air is transferred to an outside air, further enhancing the heat exchange efficiency.

Furthermore, a heat sink plate is preferably attached to wall face 31a separating a compartment placing first blast fan 12 (first environment air blast path) and inside air blast path 31. With this arrangement, heat exchange is facilitated between an outside air and an air passing through inside air blast path 31.

### FOURTH EXEMPLARY EMBODIMENT

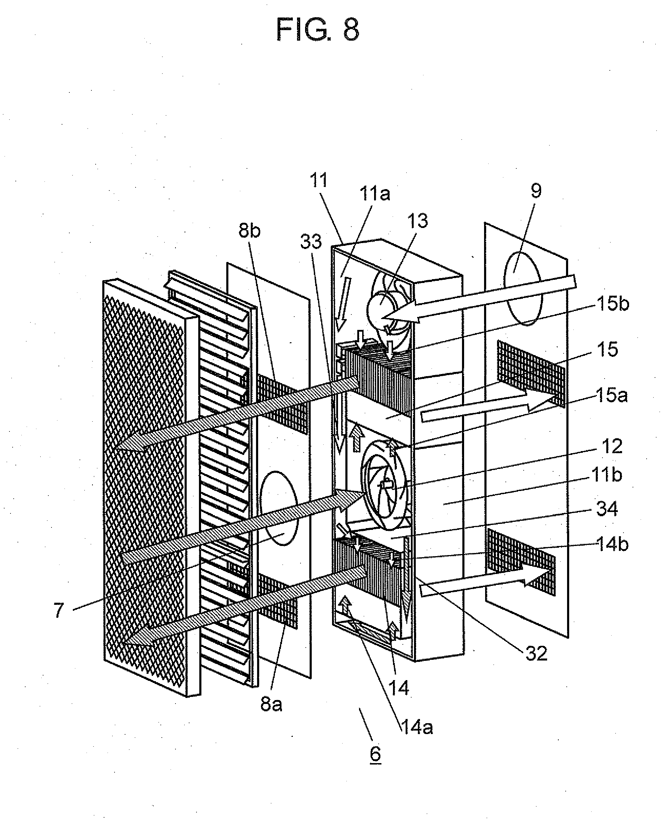

Fig 8 is an exploded perspective view of a heat exchange unit according to exemplary embodiment 4 of the invention. Embodiment 4 is explained with reference to Fig. 8. In exemplary embodiment 4 in Fig. 8, in identical to embodiment 3, first heat exchanger 14, first blast fan 12, second heat exchanger 15, and second blast fan 13 are lined up essentially in a row in this order from a bottom. Different from embodiment 3, first heat exchanger 14 has second inlet 14b for the inside air at a top thereof, and first inlet 14a for the outside air at a bottom thereof. Second heat exchanger' 15 has first inlet 15a for the outside air at a bottom thereof, and second inlet 15b for the inside air at a bottom thereof. Between side face 11b of main body case 11 and first heat exchanger 14 and first blast fan 12, outside air blast path 32 is formed. Outside air blast path 32 communicates first blast fan 12 and a bottom side of first heat exchanger 14. Between side face 11a opposing to side face 11b and second heat exchanger 15, inside air blast path 33 is formed. Inside air blast path 33 communicates second blast fan 13 and a top side of first heat exchanger 14. Between first blast fan 12 and first heat exchanger 14 and between first blast fan 12 and side face 11a, dividing plate 34 is placed forming inside air blast path 33.

Working principle of above structured heat exchange unit is explained. An inside air heated to a high temperature in cabinet 4 by transmitter-receiver 5 is drawn in by second blast fan 13 through second inflow mouth 9 of heat exchange unit 6. The drawn inside air is blasted into main body case 11. It is partially sent to second inlet 15b of second heat exchanger 15 and the rest to second inlet 14b of first heat exchanger 14 through inside air blast path 33. Meanwhile, a cool outside air is drawn in by the first blast fan through the first inflow mouth. The drawn outside air is blasted into main case 11. It is partially forwarded to first inlet 15a of second heat exchanger 15 and the rest to first inlet 14a of first heat exchanger 14 through outside air blast path 32. First heat exchanger 14 and second heat exchanger 15 transfer a heat from the hot inside air to the cool outside air. The inside air cooled down by the heat transfer is blown out to cabinet 4 through second outflow mouth 10a and 10b. The warmed up outside air is blown out to outside again through first outflow mouth 8a and 8b.

With this structure, by using two heat exchangers (first heat exchanger 14 and second heat exchanger 15) for exchanging a heat of a dimension otherwise of one heat exchanger, a cross section of the air path is larger. In other words, having two heat exchangers 14 and 15, a total dimension of air inlet 14a and 15a or of 14b and 15b is larger than a dimension of an inlet of one heat exchanger, so the cross section of the air path is larger. An air path of each heat exchanger is held shorter for passing an amount of air. Velocity of the air passing through each heat exchanger is consequently lower, enhancing heat exchange efficiency. Pressure loss for each heat exchanger is reduced. Accordingly, miniaturization of the heat exchanger is made possible.

Since first inflow mouth 7 draws in an outside air, there is a possibility that rainwater or the like comes inside. Although first heat exchanger 14 is placed under first blast fan 12, outside air blast path 32, inside air blast path 33 and dividing plate 34 are preventing it from being directly exposed to moisture from an outside.

Although not illustrated, a heat sink or other heat sink device may be attached to inside air blast path 33, at side face 11a of main body 11, where a high temperature inside air passes through. With this arrangement, heat of hot inside air is transferred to an outside air, further enhancing the heat exchange efficiency.

Furthermore, a heat sink plate is preferably attached to dividing plate 34 separating a compartment where first blast fan 12 is placed (first environment air blast path) and inside air blast path 33. With this arrangement, heat exchange is facilitated between an outside air and an air passing through air blast path 33, further enhancing heat exchange efficiency.

### INDUSTRIAL APPLICABILITY

In this invention, a plurality of heat exchangers is used so that a cross section of an air path is larger than a case when one heat exchanger is used. Namely, because a sum total of an air inlet of a plurality of heat exchangers is larger than that of one heat exchanger, the air path cross section is. The air path of each heat exchanger therefore remains short. Consequently, velocity of air passing through each heat exchanger is low, enhancing heat exchange efficiency. Pressure loss for each heat exchanger is as well reduced. Accordingly, miniaturization of the heat exchanger is possible. For this reason, the invention is useful for such as a communication equipment base station which has a limited installation space and a cooling apparatus of outdoor equipment.

### Reference marks in the drawing

1. building
2. roof
3. base station
4. cabinet
5. transmitter-receiver
6. heat exchange unit
7. first inflow mouth
8a. first outflow mouth
8b. first outflow mouth
9. second inflow mouth
10a. second outflow mouth
10b. second outflow mouth
11. main body case
12. first blast fan
13. second blast fan
14. first heat exchanger
15. second heat exchanger
16, outside air blast path
17. inside air blast path
18. blast path dividing plate
19. blast path intersection
21. dividing plate
31. inside air blast path
32. outside air blast path
33. inside air blast path
34. dividing plate

## Claims

1. A heat exchange unit comprising:
a main body case; and
a first blast fan, a second blast fan and a plurality of heat exchangers being disposed in the main body case,
wherein the main body case includes a first inflow mouth and a first outflow mouth formed in a front side thereof for a first environment, and a second inflow mouth and second outflow mouth formed in a rear side thereof for a second environment,
wherein the first blast fan blasts a first environment air drawn in through the first inflow mouth to the plurality of heat exchangers,
wherein the second blast fan blasts a second environment air drawn in through the second inflow mouth to the plurality of heat exchangers,
wherein the plurality of the heat exchangers exchange a heat between the first environment air and the second environment air in the main body case,
wherein the first heat exchanger , the second heat exchanger and the plurality of heat exchangers are lined up essentially in a row,
wherein an air blast path is formed between the plurality of heat exchangers and a wall face of the main body case,
wherein the air blast path communicates from at least one of the first blast fan and the second blast fan to the heat exchangers.

2. The heat exchange unit according to claim 1,
wherein the plurality of heat exchangers are made up of a first heat exchanger and a second heat exchanger,
wherein the first blast fan, the first heat exchanger, the second heat exchanger and the second blast fan are lined up in order, essentially in a row from a side face of the main body case,
wherein an air inlet for the first environment of the first heat exchanger and that of the second heat exchanger are directed toward the first blast fan,
wherein the air blast path is composed of an air blast path for a first environment communicating from the first blast fan to the second heat exchanger and an air blast path for a second environment communicating from the second blast fan to the first heat exchanger.

3. The heat exchange unit according to claim 2,
wherein the air blast path for the first environment and the air blast path for the second environment are formed along one side face of the main body case.

4. The heat exchange unit according to claim 2,
wherein the air blast path for the first environment and the air blast path for the second environment are respectively formed along two opposing side faces of the main body case.

5. The heat exchange unit according to claim 2,
wherein with regard to at least one of a stacking pitch for the first environment and a stacking pitch for the second environment of the first and second heat exchangers, a stacking pitch of the heat exchanger farther from one of the first blast fan and the second blast fan is larger than a stacking pitch of the heat exchanger closer to one of the first blast fan and the second blast fan.

6. The heat exchange unit according to claim 5,
wherein the stacking pitch for the first environment formed with the first heat exchanger and the stacking pitch for the second environment formed with the second heat exchanger are equal, and the stacking pitch for the second environment formed with the first heat exchanger and the stacking pitch for the first environment formed with the second exchanger are equal.

7. The heat exchange unit according to claim 1,
wherein the heat exchangers are made up of a first heat exchanger and a second heat exchanger,
wherein the first heat exchanger, the first blast fan, the second heat exchanger and the second blast fan are disposed in order from one side face of the main body case.

8. The heat exchange unit according to claim 7,
wherein an air inlet for the first environment of the first and second heat exchangers are directed toward the first blast fan,
wherein the air blast path is an air blast path for the second environment communicating from the second blast fan to an air inlet for the second environment of the first exchanger.

9. The heat exchange unit according to claim 7,
wherein an air inlet for the second environment of the first heat exchanger and an air inlet for the first environment of the second heat exchanger are directed toward the first blast fan,
wherein the air blast path is composed of an air blast path for the first environment communicating from the first blast fan to an air inlet for the first environment of the first exchanger, and an air blast path for the second environment communicating from the second blast fan to an air inlet for the second environment of the first heat exchanger.

10. The heat exchange unit according to claim 7,
wherein a stacking pitch of the first heat exchanger for the second environment is larger than a stacking pitch of the second heat exchanger for the second environment.

11. The heat exchange unit according to claim 10,
wherein a stacking pitch of the first heat exchanger for the first environment is larger than a stacking pitch of the second heat exchanger for the first environment.

12. The heat exchange unit according to claim 2,
wherein a heat sink device is attached to a side face of the main body case forming the air blast path for the second environment.

13. The heat exchange unit according to claim 1,
wherein the heat exchanger is structured by stacking a plate formed with an L shape air blast lane,
wherein an air blasted into the blast path is forwarded to a side of a longer air blast lane of the heat exchanger.

14. The heat exchange unit according to claim 13,
wherein a dividing plate placed in the air blast path and facing an air inlet of a first and a second heat exchanger is slanted so that a wide space is given to the side of the longer air blast lane of the heat exchanger.

15. The heat exchange unit according to claim 2,
wherein a heat exchange device is attached to a dividing plate dividing the air blast path for the first environment and the air blast path for the second environment.

16. A heating object container comprising a cabinet containing a heating object and the heat exchange unit according to claim 1 installed in an opening of the cabinet.

## Amended claims

### Amended claims under Art. 19.1 PCT

**1.** (Amended) A heat exchange unit comprising:
a main body case; and
a first blast fan, a second blast fan and a plurality of heat exchangers being disposed in the main body case,
wherein the main body case includes a first inflow mouth and a first outflow mouth formed in a front side thereof for a first environment, and a second inflow mouth and second outflow mouth formed in a rear side thereof for a second environment,
wherein the first blast fan blasts a first environment air drawn in through the first inflow mouth to the plurality of heat exchangers,
wherein the second blast fan blasts a second environment air drawn in through the second inflow mouth to the plurality of heat exchangers,
wherein the plurality of the heat exchangers exchange a heat between the first environment air and the second environment air in the main body case,
wherein the first air blast fan , the second air blast fan and the plurality of heat exchangers are lined up essentially in a row,
wherein an air blast path is formed between the plurality of heat exchangers and a wall face of the main body case,
wherein the air blast path communicates from at least one of the first blast fan and the second blast fan to the heat exchangers.

**2.** The heat exchange unit according to claim 1,
wherein the plurality of heat exchangers are made up of a first heat exchanger and a second heat exchanger,
wherein the first blast fan, the first heat exchanger, the second heat exchanger and the second blast fan are lined up in order, essentially in a row from a side face of the main body case,
wherein an air inlet for the first environment of the first heat exchanger and that of the second heat exchanger are directed toward the first blast fan,
wherein the air blast path is composed of an air blast path for a first environment communicating from the first blast fan to the second heat exchanger and an air blast path for a second environment communicating from the second blast fan to the first heat exchanger.

**3.** The heat exchange unit according to claim 2,
wherein the air blast path for the first environment and the air blast path for the second environment are formed along one side face of the main body case.

**4.** The heat exchange unit according to claim 2,
wherein the air blast path for the first environment and the air blast path for the second environment are respectively formed along two opposing side faces of the main body case.

**5.** The heat exchange unit according to claim 2,
wherein with regard to at least one of a stacking pitch for the first environment and a stacking pitch for the second environment of the first and second heat exchangers, a stacking pitch of the heat exchanger farther from one of the first blast fan and the second blast fan is larger than a stacking pitch of the heat exchanger closer to one of the first blast fan and the second blast fan.

**6.** The heat exchange unit according to claim 5,
wherein the stacking pitch for the first environment formed with the first heat exchanger and the stacking pitch for the second environment formed with the second heat exchanger are equal, and the stacking pitch for the second environment formed with the first heat exchanger and the stacking pitch for the first environment formed with the second exchanger are equal.

**7.** The heat exchange unit according to claim 1,
wherein the heat exchangers are made up of a first heat exchanger and a second heat exchanger,
wherein the first heat exchanger, the first blast fan, the second heat exchanger and the second blast fan are disposed in order from one side face of the main body case.

**8.** The heat exchange unit according to claim 7,
wherein an air inlet for the first environment of the first and second heat exchangers are directed toward the first blast fan,
wherein the air blast path is an air blast path for the second environment communicating from the second blast fan to an air inlet for the second environment of the first exchanger.

**9.** The heat exchange unit according to claim 7,
wherein an air inlet for the second environment of the first heat exchanger and an air inlet for the first environment of the second heat exchanger are directed toward the first blast fan,
wherein the air blast path is composed of an air blast path for the first environment communicating from the first blast fan to an air inlet for the first environment of the first exchanger, and an air blast path for the second environment communicating from the second blast fan to an air inlet for the second environment of the first heat exchanger.

**10.** The heat exchange unit according to claim 7,
wherein a stacking pitch of the first heat exchanger for the second environment is larger than a stacking pitch of the second heat exchanger for the second environment.

**11.** The heat exchange unit according to claim 10,
wherein a stacking pitch of the first heat exchanger for the first environment is larger than a stacking pitch of the second heat exchanger for the first environment.

**12.** The heat exchange unit according to claim 2,
wherein a heat sink device is attached to a side face of the main body case forming the air blast path for the second environment.

**13.** The heat exchange unit according to claim 1,
wherein the heat exchanger is structured by stacking a plate formed with an L shape air blast lane,
wherein an air blasted into the blast path is forwarded to a side of a longer air blast lane of the heat exchanger.

**14.** The heat exchange unit according to claim 13,
wherein a dividing plate placed in the air blast path and facing an air inlet of a first and a second heat exchanger is slanted so that a wide space is given to the side of the longer air blast lane of the heat exchanger.

**15.** The heat exchange unit according to claim 2,
wherein a heat exchange device is attached to a dividing plate dividing the air blast path for the first environment and the air blast path for the second environment.

**16.** A heating object container comprising a cabinet containing a heating object and the heat exchange unit according to claim 1 installed in an opening of the cabinet.
